Europäisches Patentamt

European Patent Office

Office européen des brevets

(19)

(11) Veröffentlichungsnummer: **0 202 254**
**B1**

(12)                    EUROPÄISCHE PATENTSCHRIFT

(45) Veröffentlichungstag der Patentschrift: **13.06.90**

(51) Int. Cl.⁵: **H 01 L 23/52**

(21) Anmeldenummer: **85905390.2**

(22) Anmeldetag: **25.10.85**

(86) Internationale Anmeldenummer:
**PCT/DE85/00414**

(87) Internationale Veröffentlichungsnummer:
**WO 86/03340 05.06.86 Gazette 86/12**

(54) **HALBLEITERANORDNUNG MIT METALLISIERUNG.**

(30) Priorität: **30.11.84 DE 3443771**

(43) Veröffentlichungstag der Anmeldung:
**26.11.86 Patentblatt 86/48**

(45) Bekanntmachung des Hinweises auf die
Patenterteilung:
**13.06.90 Patentblatt 90/24**

(84) Benannte Vertragsstaaten:
**DE FR GB**

(56) Entgegenhaltungen:
**EP-A- 33 130**

**IBM Technical Disclosure Bulletin, vol. 21, no. 1,
June 1978, New York (US), R.T. Dennison:
"Dynamic rando m-access memory
characteristics at power-on time", pages 190-
193**

(73) Patentinhaber: **ROBERT BOSCH GMBH
Postfach 50
D-7000 Stuttgart 1 (DE)**

(72) Erfinder: **CONZELMANN, Gerhard
Wilhelmstrasse 37
D-7022 Leinfelden-Echterdingen 1 (DE)**
Erfinder: **NAGEL, Karl
Grundstrasse 24
D-7413 Gomaringen (DE)**

Courier Press, Leamington Spa, England.

## Beschreibung

### Stand der Technik

Die Erfindung betrifft eine Halbleiteranordnung nach dem jeweiligen Oberbegriff der einander nebengeordneten Patentansprüche 1 und 2.

Halbleiteranordnungen wie Zündtransistoren, aber auch Abfangschaltungen in integrierten Schaltkreisen, die in der Erprobung und teilweise auch im praktischen Betrieb hohen thermischen Stoßbelastungen ausgesetzt werden, zeigen nach einiger Zeit häufig eine Zerrüttung ihrer Metallisierung. Integrierte Schaltkreise für Kraftfahrzeuge enthalten meist Abfangschaltungen, die sie gegen Überspannungen des Bordnetzes schützen. Diese Schaltungen erfordern relativ große Flächen und werden bis an die Grenze der physikalisch möglichen Belastbarkeit ausgelegt. Bei häufigen thermischen Stoßbeanspruchungen tritt bei diesen Schaltungsteilen oft eine Zerstörung der meist aus Aluminium bestehenden Metallisierung auf. In der Metallisierung können dann in Abständen feine Risse festgestellt werden, die die Metallisierung abschnittsweise unterbrechen.

Aus der Zeitschrift "IBM Technical Disclosure Bulletin", Band 21, Nr. 1, Juni 1978, S. 190 bis 193 ist ferner bereits eine Halbleiteranordnung nach dem Oberbegriff des Patentanspruchs 1 bekanntgeworden, bei der die Metallisierung den als Kontaktflächenbereich dienenden Oberflächenbereich des Halbleiterkörpers vollständig bedeckt.

### Vorteile der Erfindung

Die erfindungsgemäße Halbleiteranordnung mit den Merkmalen des Patentanspruchs 1 oder des Patentanspruchs 2 hat demgegenüber den Vorteil, daß Rißbildungen in der Metallisierung vermieden werden, wenn die Halbleiteranordnung hohen thermischen Stoßbelastungen ausgesetzt wird. Weitere Vorteile ergeben sich aus den Unteransprüchen 3 und 4.

### Zeichnung

Anhand der Zeichnung wird die Erfindung näher erläutert. Es zeigen:

Figur 1 einen Ausschnitt einer Draufsicht auf eine Halbleiteranordnung,

Figuren 2a bis 6b mehrere Ausführungsformen ohne (a) oder mit (b) strukturierter Oberfläche im Bereich von Metallisierungen.

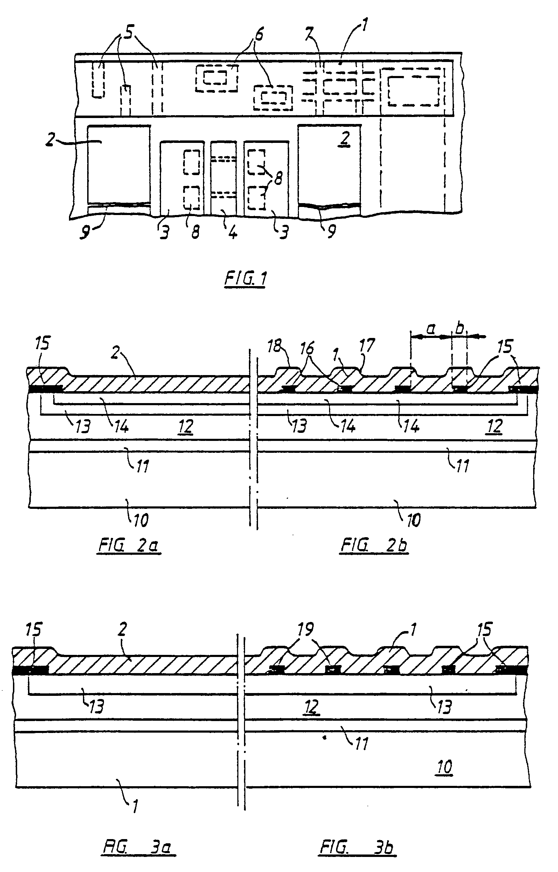

Die in Figur 1 dargestellte Halbleiteranordnung besitzt mehrere als Leiterbahnen ausgebildete Metallisierungen 1, 2, 3 und 4, bei denen nur im Bereich der Metallisierung 1 zur Erhöhung der thermischen Stoßbelastbarkeit eine Strukturierung der Oberfläche unterhalb der Metallisierung 1 vorgesehen ist. Die Umrisse der Erhebungen und Vertiefungen sind hier mit unterbrochenen Linien dargestellt. Zur Strukturierung der Oberfläche können beispielsweise Stege 5, Waben 6 oder eine Gitterstruktur 7 vorgesehen sein. Die Metallisierung 1 legt sich an diese Erhöhungen und Vertiefungen an, so daß an deren Oberfläche wenigstens annähernd gleiche Erhöhungen und Vertiefungen auftreten.

Bei der in Figur 1 dargestellten Halbleiteranordnung befinden sich nebeneinander Emitterzonen 8, die ebenfalls eine Strukturierung der Oberfläche bewirken. Durch eine geeignete Aufteilung dieser Emitterzonen kann ebenfalls die gewünschte hohe thermische Stoßspannungsfestigkeit für die darüber befindliche Metallisierung erhalten werden.

Würde man auch die Metallisierungen 2 einer hohen thermischen Stoßbelastung aussetzen, so könnten hier wegen der fehlenden Oberflächenstruktur Risse 9 auftreten.

Die in den Figuren 2a bis 6b dargestellten Ausführungsbeispiele zeigen jeweils auf der linken Seite eine bekannte Anordnung ohne Oberflächenstruktur und auf der rechten Seite die zugehörige erfindungsgemäße Anordnung mit strukturierter Oberfläche.

Die in den Figuren 2a und 2b dargestellten Anordnungen bestehen aus einem Silizium-Substrat 10, einem Buried-Layer 11, einer darüber angeordneten Epitaxie 12, einer Basis-Diffusionszone 13, einer Emitterdiffusion 14, einem an der Oberfläche angeordneten Oxid 15 und einer darüber angeordneten Metallisierung 1 bzw. 2. Die in Figur 2a dargestellte Metallisierung wurde entsprechend der in Figur 1 dargestellten, nicht strukturierten Metallisierung mit der Bezugsziffer 2 versehen. Die in Figur 2b dargestellte Metallisierung 1 weist dagegen eine Strukturierung auf, die im wesentlichen der an der Oberfläche der Halbleiteranordnung durch mehrere Oxidstege 16 gebildeten Oberflächenstruktur entspricht. Die Vertiefungen 17 und Erhebungen 18 gewährleisten in Verbindung mit der unter der Metallisierung 1 entsprechend strukturierten Oberfläche, daß bei auftretenden Energiestößen und der dadurch bedingten thermischen Stoßbelastung im Bereich der Metallisierung 1 auch bei hohen Temperaturen keine Risse auftreten.

In Figur 2b liegt die Metallisierung 1 über der Emitterdiffusion 14, mit der sie in sperrschichtfreiem Kontakt ist. Die Dickenschwankung an der Oberfläche wird nun dadurch erreicht, daß beim Freiätzen des Emitter-Kontaktfensters durch eine Strukturierung der Kontaktfenstermaske in diesem Bereich die Oxidstege 16 stehen bleiben. Breite und Abstände dieser Stege lassen sich leicht so einrichten, daß selbst bei sehr hohen Stromdichten im Emitter die Emitterfunktion nicht beeinträchtigt wird. Je nach Anwendungsfall können die Stegbreiten b beispielsweise in einem Bereich zwischen 4—50 µm liegen. Die Abstände a zwischen den Stegen können dabei in einem Bereich von 20—100 µm liegen. Die Dickenschwankungen liegen ebenfalls im µm-Bereich und können auch weniger als 1 µm betragen.

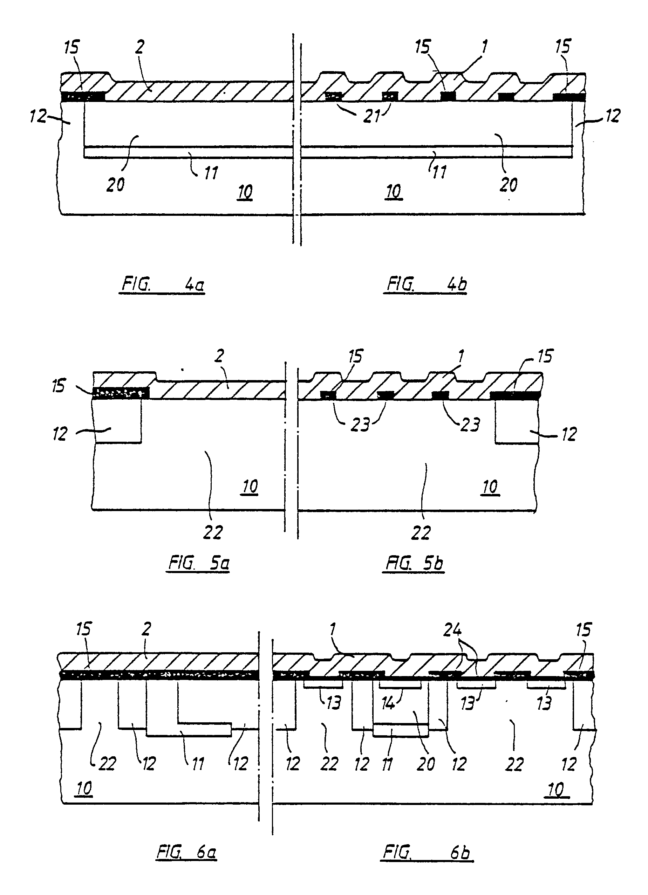

In den Figuren 3a, 3b dienen die Metallisierungen 1, 2 als Basis-Verbindungsleitungen. In Figur 3b sind ebenfalls wie bei Figur 2b Oxidstege 19 vorgesehen. Bei einer Kombination der Anordnungen nach Figur 2b und Figur 3b kann es vorteilhaft sein, die stirnseitig benachbarten Stege 16 und 19 auf Lücke versetzt anzuordnen.

In den Figuren 4a und 4b sind Anordnungen mit tiefem Kollektor 20 dargestellt. Auch hier kann im Bereich der Metallisierung 1 eine Oberflächenstrukturierung durch Oxidstege 21 erreicht werden.

Auch im Bereich der Isolierungsdiffusion 22 von Figur 5b läßt sich eine entsprechende Strukturierung mittels geeigneter Oxidstrukturen, die hier als Oxidstege 23 dargestellt sind, erzielen. Da Isolierungs- und Kollektortief-Diffusion tief eingetrieben werden, können hier je nach Herstellungsverfahren bereits schon im Diffusionsfenster schmale Stege stehen bleiben. Darüber hinaus können im Bereich der Basis-, Kollektorund/oder Isolierungsdiffusion mittels einer eingebrachten Emitter-Diffusion Stufen erzeugt werden. In entsprechender Weise kann dies im Bereich der Isolierungs- und Kollektortief-Diffusion mittels der Basis-Diffusion erfolgen.

In den Figuren 6a und 6b sind die Metallisierungen 1, 2 mittels eines durchgehenden Oxids 15 gegen den Siliziumkörper isoliert. Im Verlauf des in Figur 6b dargestellten Oxids 15 sind Dickenstufen 24 vorgesehen, die bei der aufgebrachten Metallisierung 1 eine entsprechende Strukturierung hervorrufen. Die Dickenstufen 24 können dadurch erzeugt werden, daß in Bereichen über Isolierungsdiffusion 22 eine Basisdiffusion 13 und im Bereich eines Tiefenkollektors 20 eine Emitterdiffusion 14 eingebracht werden. In unkritischen Bereichen der Epitaxie 12 kann Emitterdiffusion oder eventuell auch Basisdiffusion eingebracht werden.

Die Rückseite eines Chips kann in entsprechender Weise durch Ätzen mit einer Strukturierung versehen werden. Dies kann über den gesamten Wafer in einer einheitlichen Strukturierung erfolgen. Es kann aber auch für einzelne Chips eine jeweils zugeordnete Strukturierung vorgenommen werden.

Die Herstellung der Erhebungen und Vertiefungen zur Erzeugung einer strukturierten Oberfläche kann beim Ätzen der Kontaktfenster oder durch einen gesonderten Fotolack- und Ätzprozeß erfolgen. Die Maskierung zum Ätzen der Kontaktfenster kann dabei auch zum Ätzen des Siliziums mitverwendet werden.

## Patentansprüche

1. Halbleiteranordnung mit einem Halbleiterkörper (10, 11, 12, 13, 14), einer mindestens eine seiner Oberflächen teilweise bedeckenden Schicht (15) aus dem Oxid des Halbleitermaterials und mit mindestens einer Metallisierung (1), die auf den mit der Oxidschicht (15) versehenen Halbleiterkörper (10, 11, 12, 13, 14) derart aufgebracht ist, daß sie an den mit der Oxidschicht (15) nicht bedeckten, als Kontaktflächenbereiche dienenden Oberflächenbereichen des Halbleiterkörpers unmittelbar auf dem Halbleiterkörper aufliegt, dadurch gekennzeichnet, daß innerhalb der genannten Kontaktflächenbereiche jeweils mehrere weitere Teile (16, 19, 21, 23) der Oxidschicht (15), in Abständen sich wiederholend, unter der Metallisierung (1) derart angeordnet sind, daß die Metallisierung (1) innerhalb der genannten Kontaktflächenbereiche wellig ausgebildet ist (Figur 2b, 3b, 4b, 5b).

2. Halbleiteranordnung mit einem Halbleiterkörper (10, 11, 12, 13, 14) mit mindestens einer in ihm eindiffundierten Diffusionszone (22), einer mindestens eine seiner Oberflächen teilweise bedeckenden Schicht (15) aus dem Oxid des Halbleitermaterials und mit mindestens einer Metallisierung (1), die auf den mit der Oxidschicht (15) versehenen Halbleiterkörper (10, 11, 12, 13, 14) derart aufgebracht ist, daß sie an den mit der Oxidschicht (15) bedeckten, als Leiterbahnbereiche dienenden Oberflächenbereichen des Halbleiterkörpers auf der Oxidschicht (15) aufliegt, dadurch gekennzeichnet, daß innerhalb der genannten Leiterbahnbereiche jeweils mehrere Teile (24) der Oxidschicht (15), in Abständen sich wiederholend, in ihrer Dicke derart geschwächt sind, daß die Metallisierung (1) innerhalb der genannten Leiterbahnbereiche wellig ausgebildet ist, wobei die genannten Schwächungen durch zusätzliche Diffusionszonen (13, 14) hervorgerufen sind, die in den Halbleiterkörper in Oberflächenbereiche eindiffundiert sind.

3. Halbleiteranordnung nach Anspruch 1 oder 2 dadurch gekennzeichnet, daß die Breite (b) der Teile (16) der Oxidschicht (15) im Bereich von 4 bis 50 µm und deren Abstände (a) zueinander im Bereich von 20 bis 100 µm liegen (Figur 2b).

## Revendications

1. Dispositif semi-conducteur comportant un corps semi-conducteur (10, 11, 12, 13, 14), une couche (15) qui recouvre au moins partiellement sa surface, cette couche étant constituée par l'oxyde du matériau semi-conducteur et comporte au moins une couche de métallisation (1) qui est appliquée sur le corps semiconducteur (10, 11, 12, 13, 14) muni de la couche d'oxyde (15) pour venir s'appliquer sur les zones du corps du semi-conducteur, directement sur le corps du semi-conducteur, pour les zones qui ne sont pas recouvertes par la couche d'oxyde (15) et servent de zones de surface de contact, dispositif caractérisé en ce qu'à l'intérieur des zones de surface de contact, on a respectivement prévu plusieurs autres parties (16, 19, 21, 23) de la couche d'oxyde (15), qui se répètent à des intervalles, par métallisation (1) de manière que la métallisation (1) présente une forme ondulée à l'intérieur des zones de surface de contact ci-dessus (figures 2b, 3b, 4b, 5b).

2. Dispositif semi-conducteur comportant un corps semi-conducteur (10, 11, 12, 13, 14) avec au moins une zone de diffusion (22) diffusée en profondeur, au moins une couche (15) d'oxyde du matériau semi-conducteur recouvrant partiellement la surface du corps et au moins une couche de métallisation (1) qui est appliquée sur le corps semiconducteur (10, 11, 12, 13, 14) muni de la couche d'oxyde (15) de manière à venir sur les zones de surface du corps semi-conducteur non recouverte par la couche d'oxyde (15) et servant de zone de chemin conducteur, caractérisé en ce qu'à l'intérieur des zones de chemin conducteur ci-dessus, chaque fois plusieurs parties (24) de la couche d'oxyde (15) sont diminuées en épaisseur de manière répétée à des intervalles pour que la métallisation (2) présente une forme ondulée à l'intérieur des zones de chemin conducteur ci-dessus, les affaiblissements ainsi mentionnés étant réalisés par des zones de diffusion supplémentaires (13, 14) qui sont diffusées dans les zones de surface du corps semi-conducteur.

3. Dispositif semi-conducteur selon la revendication 1 ou 2, caractérisé en ce que la largeur (b) des parties (16) de la couche d'oxyde (15) est comprise entre 4 et 50 microns et leur écartement (a) est compris entre 20 et 100 microns (figure 2b).

**Claims**

1. Semiconductor device comprising a semiconductor body (10, 11, 12, 13, 14), a layer (15) composed of the oxide of the semiconductor material and partially covering at least one of its surfaces, and comprising at least one metallization (1) which is deposited in such a manner on the semiconductor body (10, 11, 12, 13, 14) provided with the oxide layer (15) that it rests directly on the semiconductor body at the surface regions of the semiconductor body which are not covered with the oxide layer (15) and serve as contact area regions, characterized in that, within the said contact area regions, a plurality of further parts (16, 19, 21, 23) of the oxide layer (15) is arranged in each case repetitively at intervals beneath the metallization (1) in a manner such that the metallization (1) is of corrugated construction within the said contact area regions (Figures 2b, 3b, 4b, 5b).

2. Semiconductor device comprising a semiconductor body (10, 11, 12, 13, 14) comprising at least one diffusion zone (22) diffused into it, a layer (15) composed of the oxide of the semiconductor material and partially covering at least one of its surfaces, and comprising at least one metallization (1) which is deposited in such a manner on the semiconductor body (10, 11, 12, 13, 14) provided with the oxide layer (15) that it rests on the oxide layer (15) at the surface area regions of the semiconductor body which are covered with the oxide layer (15) and serve as conductor track regions, characterized in that, within the said conductor track regions, a plurality of parts (24) of the oxide layer (15) are in each case reduced in their thickness repetitively at intervals in a manner such that the metallization (1) is of corrugated constuction within the said conductor track regions, the reductions mentioned being produced by additional diffusion zones (13, 14) which are diffused into the semiconductor body in surface regions.

3. Semiconductor device according to Claim 1 or 2, characterized in that the width (b) of the parts (16) of the oxide layer (15) is in the region of 4 to 50 µm and their spacings (a) from one another are in the region of 20 to 100 µm (Figure 2b).

FIG. 1

FIG. 2a          FIG. 2b

FIG. 3a          FIG. 3b

_FIG. 4a_

_FIG. 4b_

_FIG. 5a_

_FIG. 5b_

_FIG. 6a_

_FIG. 6b_